Europäisches Patentamt

European Patent Office

Office européen des brevets

(19)

(11) Veröffentlichungsnummer : **0 082 208**
**B1**

(12) # EUROPÄISCHE PATENTSCHRIFT

(45) Veröffentlichungstag der Patentschrift :
21.11.85

(21) Anmeldenummer : 81110521.2

(22) Anmeldetag : 17.12.81

(51) Int. Cl.⁴ : **H 03 K 19/094, H 03 K 5/02**

(54) Integrierter CMOS-Schaltkreis.

(43) Veröffentlichungstag der Anmeldung :
29.06.83 Patentblatt 83/26

(45) Bekanntmachung des Hinweises auf die Patenterteilung : 21.11.85 Patentblatt 85/47

(84) Benannte Vertragsstaaten :
DE FR GB IT NL

(56) Entgegenhaltungen :
EP-A- 0 031 582
DE-A- 2 737 544
DE-A- 2 741 821
GB-A- 2 018 540
ELECTRONIC DESIGN, Band 29, Nr.25, Dezember
1981, Waseca, MN (US) A. JAFFER: "Boost voltage,
translate clock level for improved CMOS-circuit operation", Seiten 176-178
RADIO FERNSEHEN ELEKTRONIK, Band 30, Nr.3,
März 1981, Berlin (DE) G. NICKLISCH et al.:"Programmieren von EPROMs", Seiten 177-179

(73) Patentinhaber : Deutsche ITT Industries GmbH
Hans-Bunte-Strasse 19 Postfach 840
D-7800 Freiburg (DE)
DE
ITT INDUSTRIES INC.
320 Park Avenue
New York, NY 10022 (US)
FR GB IT NL

(72) Erfinder : Adam, Fritz Günter Dr. rer. nat Dipl.-Phys.
Furtwänglerstrasse 10
D-7800 Freiburg (DE)

(74) Vertreter : Morstadt, Volker, Dipl.-Ing.. et al
c/o Deutsche ITT Industries GmbH Patent/Lizenzab-
teilung Postfach 840 Hans-Bunte-Strasse 19
D-7800 Freiburg/Brsg. (DE)

**Beschreibung**

CMOS-Schaltkreise bieten gegenüber Schaltkreisen, die in Einkanaltechnologie hergestellt sind, zwei Hauptvorteile :

1) Ihre Ruheverlustleistung ist meist vernachlässigbar klein, da diese nur von Sperrströmen verursacht wird.

2) Sie können am Ausgang zum Betrieb einer Nutzlast eine sehr niederohmige Spannungsquelle zur Verfügung stellen.

Diese beiden Vorteile tragen dazu bei, daß CMOS-Schaltkreise bevorzugt auch bei höheren Betriebsspannungen eingesetzt werden. Die Verlustleistung der in Sourceschaltung arbeitenden Ausgangstransistoren kann durch ein großes W/L-Verhältnis auch bei Belastung nahezu unabhängig von der Spannung sehr klein gehalten werden.

Mit wachsender Betriebsspannung $U_B$ steigt jedoch die an den Gateelektroden der Ausgangstransistoren benötigte Ansteuerleistung Pg quadratisch an und kann besonders bei großer Gatekapazität

$$Cg = W \cdot L \cdot Cox$$

mit W = Kanalbreite, L = Kanallänge, Cox = spezifische Kapazität, und bei hoher Frequenz f störend werden :

$$Pg = f \, Cg \, U_B^2.$$

Diese Ansteuerleistung fällt auch an, wenn am Ausgang nicht eine Nutzleistung, sondern lediglich eine hohe Spannung benötigt wird. Dies gilt beispielsweise im Falle einer Peripherieschaltung für die Programmierung von nichtflüchtig speichernden Feldeffektspeichertransistoren einer Speichermatrix, wie sie beispielsweise aus der EP-A1-00 20054 bekannt ist.

Im Falle einer solchen Speichermatrix verteilt sich die für die Programmierung erforderliche Ansteuerleistung auf eine Vielzahl von Transistoren. Bei einem 16k-Matrixspeicher mit N-Kanal-Floating-Gate-Zellen, organisiert in 128 Zeilen und 128 Spalten, wird es sich z. B. um 128 Schalttransistoren handeln, deren Gateelektroden kurzzeitig auf eine Programmierspannung von etwa 20 V gebracht werden müssen.

Die Erfindung betrifft einen integrierten CMOS-Schaltkreis gemäß dem Oberbegriff des Anspruchs 1, wie er aus der DE-A1-27 37 544 bekannt ist.

Bei diesem integrierten CMOS-Schaltkreis wird der in der Leistungsstufe fließende Querstrom und damit deren Verlustleistung dadurch wesentlich verringert, daß die erste und die zweite Treiberstufe durch das Eingangssignal gleichzeitig angesteuert wird, daß die Steuerelektrode des einen Transistors der Endstufe an den Stufenausgang der einen Vorstufe und die Steuerelektrode des anderen Transistors der Endstufe an den Stufenausgang der anderen Vorstufe angeschlossen ist und daß der Durchlaßwiderstand des P-Kanal-Transistors in der den P-Kanal-Transistor der Endstufe steuernden Treiberstufe und der Durchlaßwiderstand des N-Kanal-Transistors in der den N-Kanal-Transistor der Endstufe steuernden Treiberstufe kleiner ist als der Durchlaßwiderstand des jeweils anderen Transistors in der ersten und zweiten Treiberstufe. Damit allein läßt sich jedoch nicht die von den Gatekapazitäten benötigte Ansteuerleistung wesentlich vermindern, da die CMOS-Inverter der Vorstufen den vollen Hub der Versorgungsspannung durchschalten.

Es ist nun die Aufgabe der Erfindung, für einen solchen für höhere Spannungen vorgesehenen Schaltkreis, bei dem die Ansteuerleistung eine nicht akzeptable Größe erreicht oder dessen Realisierung sich der Ansteuerleistung wegen verbietet, eine Lösung anzugeben, die die Ansteuerleistung wesentlich vermindert.

Die Erfindung geht von dem Gedanken aus, solche für relativ hohe Spannungen vorgesehene Schaltkreise zur Verminderung der Verlustleistung zunächst einmal in der CMOS-Technologie auszuführen, d. h. unter Verwendung von Gattern, welche komplementäre Isolierschicht-Feldeffekttransistoren aufweisen.

Die oben genannte Aufgabe der Verminderung der Ansteuerleistung wird erfindungsgemäß durch die im kennzeichnenden Teil des Anspruchs 1 angegebene Ausbildung gelöst.

Entsprechend dem Grundgedanken der Erfindung wird also entsprechend dem bekannten Stand der Technik das Eingangssignal nicht an die miteinander verbundenen Gateelektroden angelegt, sondern getrennt über eine Treiberstufe, welche zur Erzeugung von zwei Treibersignalen gleichen Vorzeichens dient, die gleichzeitig an je eine Gateelektrode der komplementären Feldeffekttransistoren angelegt werden und jeweils die Source-Gate-Spannung eines der beiden Feldeffekttransistoren über dessen Schwellenspannung anhebt. Da die Schwellenspannungen der Feldeffekttransistoren sehr gering gewählt werden können, sind bei dem CMOS-Schaltkreis nach der Erfindung lediglich relativ kleine Spannungen erforderlich, um den integrierten CMOS-Schaltkreis umzuschalten. Bei dem bekannten CMOS-Schaltkreis wird dagegen die Source-Gate-Spannung des geschalteten Feldeffekttransistors beträchtlich über dessen Schwellenspannung erhöht.

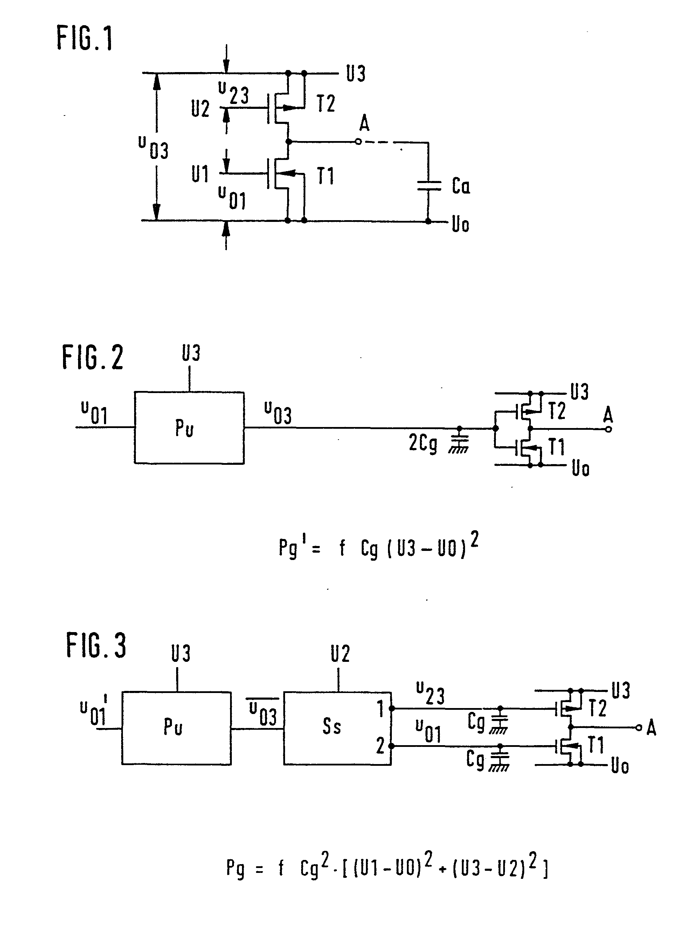

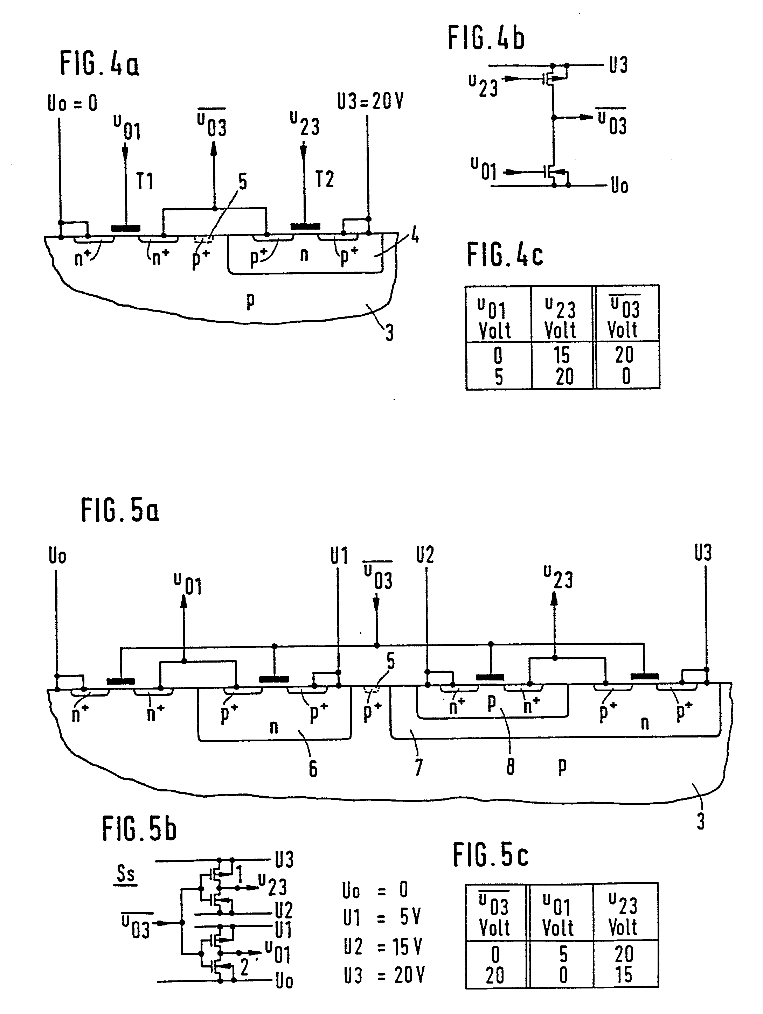

Die Merkmale und Vorteile des integrierten CMOS-Schaltkreises nach der Erfindung werden im folgenden anhand der Zeichnung erläutert,

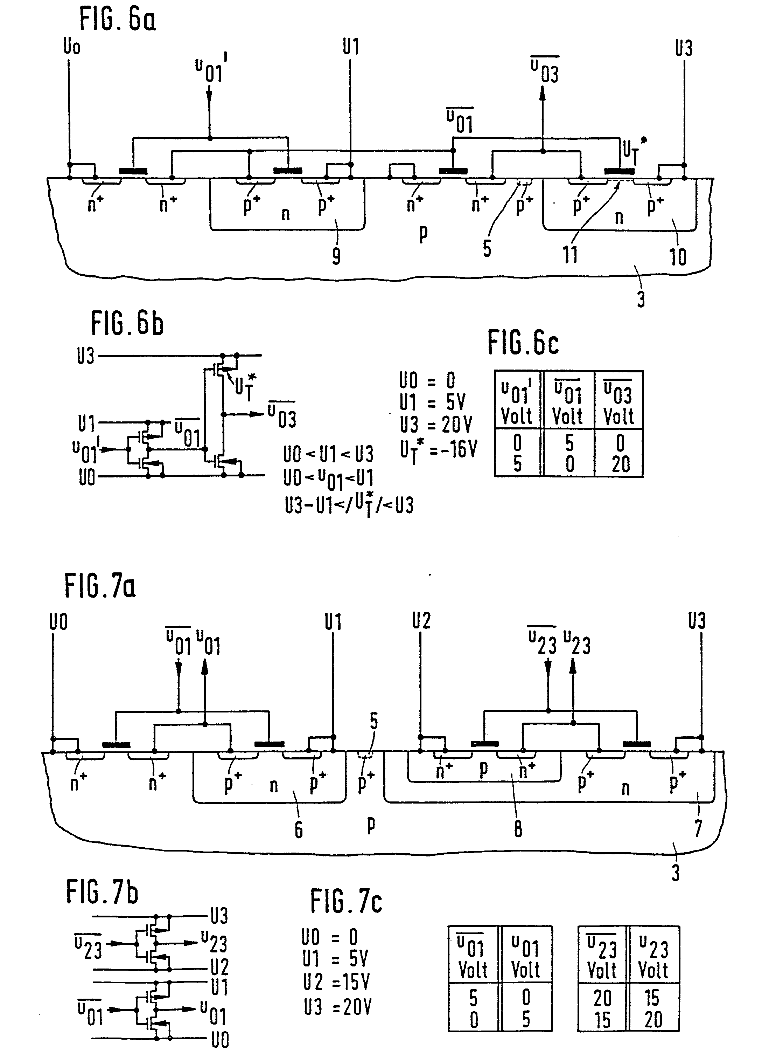

deren Figuren 1 bis 3 zur Erklärung der Unterschiede des integrierten CMOS-Schaltkreises nach der Erfindung gegenüber einem herkömmlichen Schaltkreis dienen,

deren Figur 4 ein CMOS-Gatter zur Verwendung in dem CMOS-Schaltkreis nach der Erfindung zeigt,

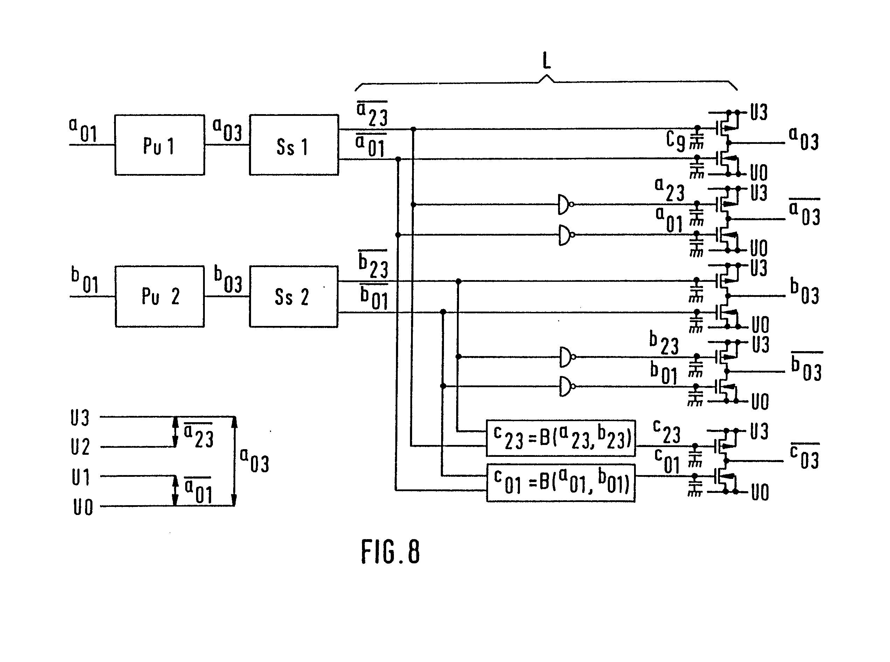

deren Figur 5 die monolithische Integration einer Treiberstufe und deren Schaltbild mit einer Tabelle der angelegten Spannungen enthält,

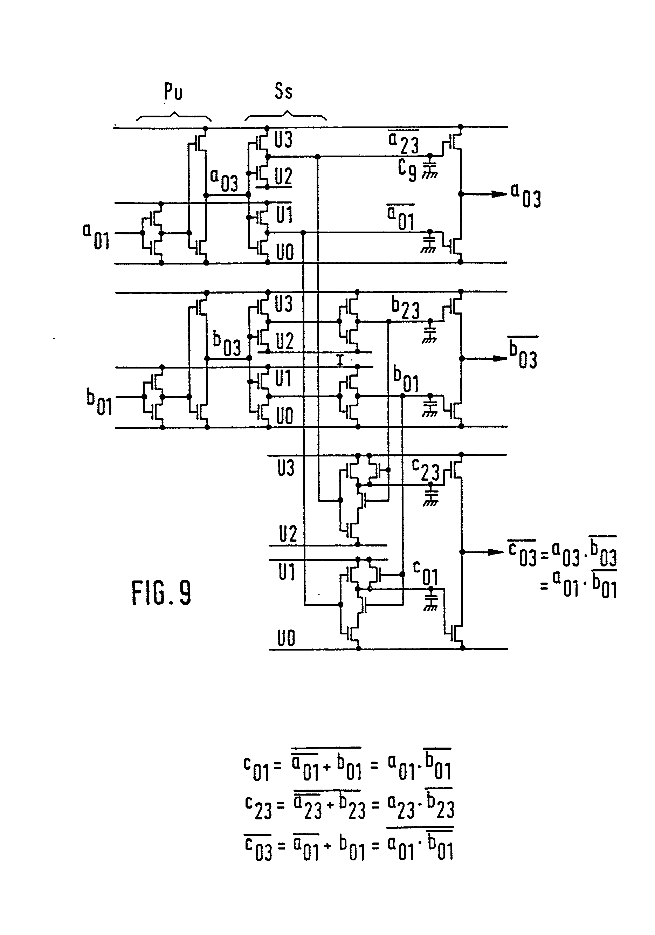

deren Figur 6 einen monolithisch integrierten Pegelumsetzungsschaltkreis, dessen Schaltbild und dessen Betriebsdaten veranschaulicht,

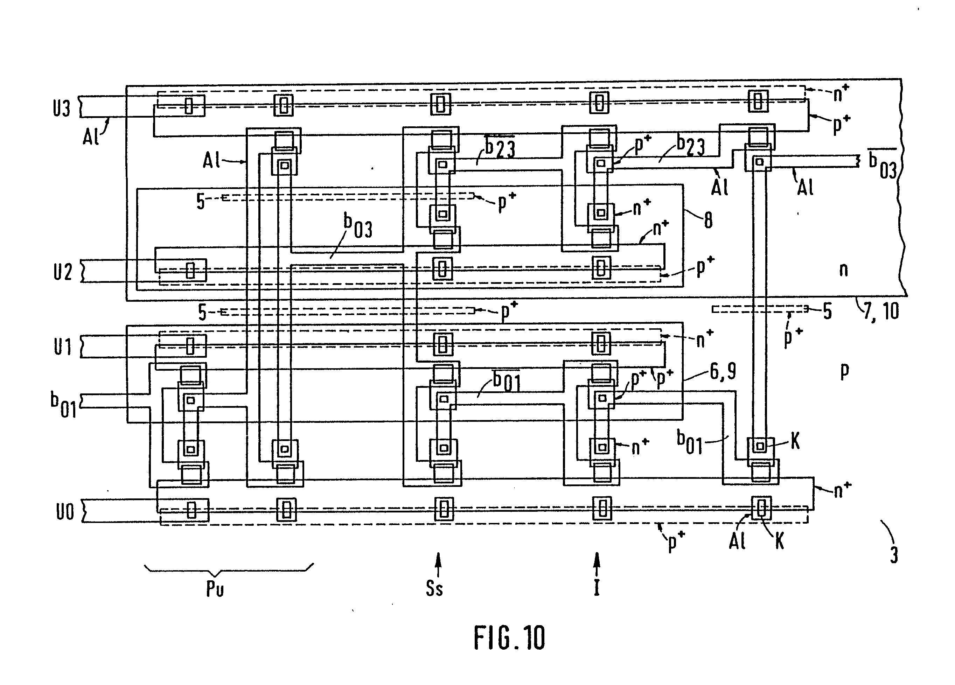

deren Figur 7 einen monolithisch integrierten Schaltkreis zur Invertierung der getrennten Treibersignale betrifft,

deren Figur 8 ein Prinzipschaltbild zeigt, welches zur Erläuterung der logischen Verknüpfung von Treibersignalen dient,

deren Figur 9 die Schaltung einer entsprechend Fig. 8 aufgebauten Verknüpfungsschaltung enthält und

deren Figur 10 in Aufsicht ein Auslegungsbeispiel für einen Teil der Verknüpfungsschaltung gemäß der Fig. 9 veranschaulicht.

Die Erfindung geht aus von dem bekannten CMOS-Gatter gemäß der Fig. 1, bei dem die Gateelektroden der beiden Feldeffekttransistoren T1 und T2 nicht verbunden, sondern getrennt angesteuert sind.

Die Blockschaltbilder der Fig. 2 und 3 dienen zum Vergleich einer Lösung mit nicht getrennt angesteuerten Gateelektroden entsprechend dem bekannten Stand der Technik nach Fig. 2 der Zeitschrift « Elektronik » (1971), Heft 4, Seiten 111 bis 116, einerseits und entsprechend der Erfindung gemäß der Fig. 3 andererseits. Es wird davon ausgegangen, daß gemäß diesem Stand der Technik in einem vorgeschalteten Schaltkreis zunächst die Steuersignale $u_{01}$ bzw. $u_{01'}$ auf einem niedrigen Spannungspegel U1 erzeugt werden, um erst dann möglichst unmittelbar vor Erzeugung des Nutzsignals $u_{03}$ bzw. $\overline{u_{03}}$, auf die hohe Spannung U3 durch Pegelumsetzung mittels des Pegelumsetzers Pu überzugehen. Cg bedeutet eine Gatekapazität, während Ca gemäß er Fig. 1 eine an den Ausgang A angeschlossene kapazitive Last ist, wie es bei der Ansteuerung von Wortleitungen einer Speichermatrix mit nichtflüchtig lesbaren Feldeffekt-Speichertransistoren der Fall ist.

Während bei dem CMOS-Schaltkreis gemäß der Fig. 2 das Steuersignal $u_{03}$ unmittelbar zur Umladung der Ansteuerkapazität 2 Cg verwendet wird, wird entsprechend der Erfindung gemäß der Fig. 3 eine Treiberstufe Ss verwendet, welche zur Aufspaltung des Eingangssignals $\overline{u_{03}}$ in die beiden Treibersignale $u_{23}$ und $u_{01}$ dient, welche an den beiden Ausgängen 1 bzw. 2 auftreten und an die Gateelektroden je eines der beiden Feldeffekttransistoren T1 und T2 angelegt werden.

Während bei dem CMOS-Schaltkreis gemäß der Fig. 2 eine Umladung der Kapazität 2 Cg zwischen U3 und U0 erfolgt, wird bei dem CMOS-Schaltkreis gemäß der Fig. 3 die Gatekapazität Cg des Feldeffekttransistors T2 zwischen U3 und U2 und die des Feldeffekttransistors T1 zwischen U1 und U0 umgeladen.

In einem praktischen Ausführungsbeispiel, passend für die Versorgung einer Wortleitung einer Speichermatrix mit N-Kanal-Floating-Gate-Speichertransistoren werden folgende Spannungswerte angenommen :

$$U0 = 0 \qquad U2 = 15\ V$$
$$U1 = 5\ V \qquad U3 = 20\ V$$

Für die Treibersignale an den Ausgängen der Treiberstufe Ss im eingeschalteten Zustand gilt somit

$$u_{01}(1) = U1 - U0 = 5\ V$$
$$u_{23}(1) = U3 - U2 = 5\ V,$$

während das Steuersignal ohne Aufspaltung für den Fall gemäß der Fig. 2

$$u_{03}(1) = U3 - U0 = 20\ V$$

betragen würde.

Das Verhältnis der Steuerverlustleistungen Pg' und Pg, wie sie durch die Ausdrücke unter den Fig. 2 und 3 gegeben sind, verhalten sich somit wie :

$$Pg/Pg' = 400/25 = 16/1.$$

Die Fig. 4 veranschaulicht für das Beispiel U0 = 0 und U3 = 20 V die Potentialverhältnisse bzw. Spannungsverhältnisse eines CMOS-Gatters, an das die zwei Treibersignale $u_{01}$ und $u_{23}$ angelegt werden. Die Fig. 4a zeigt in üblicher Querschnittsansicht die beiden Substratzonen 3 und 4, in denen die Zonen der zueinander komplementären Feldeffekttransistoren T1 und T2 untergebracht worden sind. Die Fig. 4b zeigt das entsprechende Schaltbild und die Fig. 4c tabellenmäßig die auftretenden Spannungen $u_{01}$ und $u_{23}$ an den beiden Eingängen und die Spannung $\overline{u_{03}}$ am Ausgang des Gatters.

Die Verbindung zwischen den Sourcezonen der beiden Feldeffekttransistoren wird entsprechend dem bekannten Stand der Technik als Leitbahn hergestellt, welche über die in der Schnittansicht nicht dargestellte Oberflächenschicht aus Siliciuimdioxid verläuft. Unter dieser Leitbahn ist oberflächlich in der Substratzone 3 eine hochdotierte Kanalunterbrecherzone 5 angebracht, welche das Auftreten eines parasitären Channels verhindert. In diesem Zusammenhang ist zu bemerken, daß bei dem in dem integrierten CMOS-Schaltkreis nach der Erfindung verwendeten CMOS-Gatter lediglich unter dieser Leitbahn zwischen den beiden Sourcezonen eine Kanalunterbrecherzone erforderlich ist, wie anhand der Fig. 4c erkennbar ist. Nur hier tritt nämlich eine relativ hohe Spannungsdifferenz von 20 V auf, während diese Spannungsdifferenz bei den Zuleitungen zu den Gateelektroden, welche ebenfalls als Leitbahnen auf der oberflächlichen Siliciumdioxidschicht ausgeführt sind, lediglich 5 V beträgt. Da bei den Leitbahnen zwischen Treiberstufe Ss und Ausgangsstufe gemäß der Fig. 4 somit keine hochdotierten Kanalunterbrecherzonen vom Leitungstyp der angrenzenden Substratzone erforderlich sind, ergibt sich der Vorteil einer Flächenersparnis.

Die Fig. 5 zeigt die bevorzugte Ausbildung der Treiberstufe Ss des integrierten CMOS-Schaltkreises nach der Erfindung. In der Fig. 5a ist in üblicher Querschnittsansicht als Ausschnitt einer monolithisch integrierten Festkörperschaltung die monolithischen Integration der Treiberstufe dargestellt, deren Schaltbild in Fig. 5b gezeigt wird. Diese wird in einem als Substratzone 3 verwendeten p-dotierten plattenförmigen Halbleiterkörper an einer Oberflächenseite untergebracht. In diese Oberflächenseite werden planare Substratzonen 6, 7 und 8 eindiffundiert, wobei die Substratzone 8 in die Substratzone 7 eingesetzt ist und sämtliche Substratzonen gegeneinander gleichstrommäßig durch eine PN-Übergangsfläche elektrisch gegeneinander getrennt sind.

Wie die Fig. 5b ohne weiteres erkennen läßt, besteht die Treiberstufe Ss aus zwei CMOS-Inverter mit je einem Paar von komplementären Isolierschichtfeldeffekttransistoren, an deren Gateelektroden das Eingangssignal $\overline{u_{03}}$ anliegt. Der erste Ausgang 1 der Treiberstufe Ss ist mit dem Ausgang des ersten CMOS-Inverters verbunden, dessen erster Transistor mit seiner Sourceelektrode an der einen Versorgungsspannung U3 liegt, während der zweite Ausgang 2 der Treiberstufe Ss mit dem Ausgang des zweiten CMOS-Inverters verbunden ist, dessen zweiter Transistor mit seiner Sourceelektrode an der anderen Versorgungsspannung U0 der Treiberstufe liegt. Während an dem ersten CMOS-Inverter gemäß der Fig. 5b die Versorgungsspannung U3 − U2 angelegt wird, beträgt diese beim zweiten CMOS-Inverter U1 − U0. Rechts neben dem Schaltbild gemäß der Fig. 5b findet sich ein auf die Praxis der Programmierung von nichtflüchtig programmierbaren Speichertransistoren zugeschnittenes Ausführungsbeispiel mit den Spannungen wo 0 = 0, U1 = 5 V, U2 = 15 V und U3 = 20 V. In der Tabelle 5c sind Ausgangsspannungen $u_{01}$ und $u_{23}$ für die beiden Eingangsspannungen $\overline{u_{03}}$ von 0 und 20 V angegeben. Die beiden Treibersignale sind somit nur etwas größer als die Schwellenspannungen der jeweils anzusteuernden Isolierschicht-Feldeffekttransistoren der beiden CMOS-Schaltkreise der Treiberstufe Ss. Die Tabelle 5c läßt auch hier erkennen, daß lediglich unter der die Gateelektroden verbindenden Leitbahn eine Kanalunterbrecherzone 5 zwischen den beiden Substratzonen 6 und 7 anzubringen ist.

Für eine Treiberstufe Ss gemäß der Fig. 5 ist somit die Einführung einer dritten Versorgungsspannung U2 entscheidend. Diese wird mit der p-dotierten Substratzone 8 und der Sourcezone des in ihr untergebrachten N-Kanal-Feldeffekt-transistors verbunden. Die p-dotierte Substratzone 8 ihrerseits ist in die n-dotierte Substratzone 7 eingelassen, die mit der Versorgungsspannung U3 und der Sourcezone eines in ihr angeordneten P-Kanal-Feldeffekttransistors verbunden ist. Beide Feldeffekttransistoren bilden den ersten Inverter mit dem ersten Ausgang 1.

Der P-Kanal-Feldeffekttransistor des zweiten CMOS-Inverters ist in der nächsten n-dotierten Substratzone 6 untergebracht, während die Zonen seines N-Kanal-Feldeffekttransistors unmittelbar in das p-dotierte Substrat eindiffundiert werden.

Die Fig. 6 veranschaulicht, wie die Pegelumsetzerstufe Pu gemäß der Fig. 3 realisiert werden kann. Diese Stufe, deren Schaltbild in Fig. 6b gezeigt ist, erzielt die Pegelumsetzung des Signals $\overline{u_{01}}$ auf $\overline{u_{03}}$, wobei hier die kapazitive Belastung für $u_{03}$ noch sehr klein gehalten werden kann, da noch keine Leistung wie in der Endstufe gemäß der Fig. 4 zu verarbeiten ist. Die Pegelumsetzungsstufe wird durch zwei nachgeschaltete Inverter realisiert, wobei der erste Inverter an der Versorgungsspannung U1 und der zweite Inverter an der Versorgungsspannung U3 liegt. Diese beiden Inverterstufen werden gemäß der Fig. 6a, welche eine Querschnittsansicht in übliche Darstellung der Pegelumsetzungsstufe zeigt, unter Verwendung von zwei Substratzonen 9 und 10 des ersten Leitungstyps realisiert, welche in den plattenförmigen Substratkörper 3 des anderen Leitungstyps eingesetzt sind. Bei dem mit der Sourcezone an der Versorgungsspannung U3 liegenden P-Kanal-Feldeffekttransistors des nachgeschalteten Inverters, der in der Substratzone 10 angeordnet ist, muß eine erhöhte Schwellenspannung $U_T^*$ durch Ionenimplantation in dem Kanalbereich 11 derart realisiert werden, daß die in der Fig. 6 angegebenen Beziehung

$$U3 - U1 < |U_T^*| < U3$$

gilt.

Die Tabelle 6c zeigt die Abhängigkeit des Ausgangspegels $\overline{\overline{u_{03}}}$ und des Pegels $\overline{\overline{u_{01}}}$ vom Pegel des Eingangssignals $u_{01}$, bei den neben der Tabelle angegebenen Bedingungen.

Es ist ohne weiteres möglich, die niedrigpegeligen Treibersignale logisch zu verknüpfen, wozu beispielsweise der Inverter gemäß der Fig. 7 verwendet werden kann, dessen Schaltbild in Fig. 7b und dessen monolithisch integrierte Realisierung aus Fig. 7a ohne weiteres ersichtlich ist. Allerdings ist dann im Vergleich zur Verknüpfung vor der Aufspaltung des digitalen Eingangssignals in die beiden Treibersignale der doppelte Schaltungsaufwand erforderlich. Trotzdem können auf diese Weise unter Umständen Auslegungsvorteile und/oder Verlustleistungseinsparungen erzielt werden. Außerdem wird der erhöhte Schaltungsaufwand teilweise dadurch kompensiert, daß nur wenige Kanalunterbrecherzonen erforderlich sind.

Die Fig. 8 zeigt im Blockschaltbild, auf welche Weise zwei Steuersignale $a_{01}$ und $b_{01}$ — und damit im Prinzip auch mehrere Steuersignale — auch nach ihrer Aufspaltung logisch verknüpft werden können. Die Aufspaltung erfolgt mittels der beiden Treiberstufen Ss1 und Ss2 nach einer Pegelumsetzung in Pu1 bzw. Pu2. Die aufgespalteten Signale $c_{23}$ und $c_{01}$ sind irgend welche Bool'sche Funktionen B von $a_{23}$ und $b_{23}$ bzw. von $a_{01}$ und $b_{01}$, wie es aus der Fig. 8 ersichtlich ist. Über den Bereich L wird durch Signalaufspaltung ein beträchtlicher Teil der Ansteuerleistung eingespart. Im Vergleich zu einer Verknüpfung ohne Aufspaltung des Eingangssignals in zwei Treibersignale ist zwar der doppelte Schaltungsaufwand erforderlich, wenn die Triebersignale logisch verknüpft werden. Trotzdem können auf die in Fig. 8 erläuterte Weise unter Umständen Auslegungsvorteile, beispielsweise Flächenersparnis durch Wegfall von Kanalunterbrecherzonen und/oder Verlustleistungseinsparungen erzielt werden.

Da für den Fachmann anhand der Fig. 8 die Vorteile einer logischen Verknüpfung der aufgespalteten Signale ohne weiteres ersichtlich sind, dürfte es genügen, die Schaltungseinzelheiten solcher logischer Verknüpfungen an einem einfachen Beispiel in Fig. 9 zu beschreiben.

Aus der Schaltungsanordnung der Fig. 9 ist ersichtlich, wie mit Hilfe zweier Pegelumsetzer Pu gemäß der Fig. 6 und zweier Treiberstufen SS gemäß der Fig. 5 zwei Eingangssignale $a_{01}$ und $b_{01}$ in je zwei Treibersignale $\overline{a_{23}}$ und $\overline{a_{01}}$ bzw. $b_{23}$ und $b_{01}$ übergeführt und zur Ansteuerung je einer Leistungsstufe verwendet werden, an deren Ausgang das Signal $a_{03}$ bzw. das Signal $\overline{b_{03}}$ abgegriffen werden kann. Vor der Leistungsstufe, an der das Ausgangssignal $\overline{b_{03}}$ abgegriffen wird, liegt eine Inverterstufe gemäß der Fig. 7. Zur Gewinnung eines Ausgangssignals $\overline{c_{03}} = a_{03} \cdot \overline{b_{03}}$ ist ferner eine NOR-Gatterstufe vorgesehen, deren erstes NOR-Gatter die beiden Signale $\overline{a_{01}}$ und $b_{01}$ zugeführt und an deren zweites NOR-Gatter die beiden Signale $\overline{a_{23}}$ und $b_{23}$ gemäß der unter der Schaltung der Fig. 9 ersichtlichen Tabelle angelegt werden. Die oberhalb der Ausgangsabgriffe befindlichen Feldeffekttransistoren sind P-Kanal-Feldeffekttransistoren, während die unterhalb der Ausgangsabgriffe angeordneten N-Kanal-Feldeffekttransistoren sind. Dieses Ausführungsbeispiel gemäß der Fig. 9 zeigt, daß die aufgespalteten Treibersignale logisch beliebig verknüpft werden können, indem die potentialmäßig tief liegenden Treibersignale jeweils getrennt logisch verknüpft werden. Die so gewonnenen Ausgangssignalpaare werden sodann mit je einer Gateelektrode der komplementären Isolierschicht-Feldeffekttransistoren der Leistungsstufe verbunden.

Die Fig. 10 zeigt die Auslegung des mittleren Schaltungsteils der Fig. 9, an dem das Eingangssignal $b_{01}$ anliegt, und der vor der Leistungsstufe einen Inverter gemäß der Fig. 7 enthält. Sowohl die Leiterbahnen als auch die Gateelektroden der Feldeffekttransistoren bestehen aus Aluminium (A1). In die Oberflächenseite des p-dotierten Substratkörpers 3 ist zur Realisierung des mittleren Schaltungsteils der Fig. 9 die n-dotierte Substratzone 7 eingesetzt, welche der Substratzone 7 in den Fig. 5 und 7 entspricht. Diese Substratzone 7 ist mit der Substratzone 10 der Fig. 6 zusammenhängend ausgebildet. In die Substratzone 7 ist wiederum die weitere Substratzone 8 eingelassen, welche der Substratzone 8 in den Fig. 5 und 7 entspricht. Die Sourcezonen der oberen P-Kanal-Feldeffekttransistoren und der unteren N-Kanal-Feldeffekttransistoren sind zusammenhängend in Form eines $p^+$-dotierten Zonenstreifens bzw. in Form eines $n^+$-dotierten Zonenstreifens ausgebildet, wie die Fig. 10 ohne weiteres erkennen läßt. Ferner ist in die Oberfläche des p-dotierten Substratkörpers die Substratzone 6, 9 eingesetzt — vergleiche Fig. 5, 6 und 7. Im übrigen sind die Abstände zwischen den Transistoren der Fig. 10 im Interesse der Übersichtlichkeit vergrößert worden.

Wie aus der Fig. 10 ersichtlich, sind $p^+$-dotierte Kanalunterbrecherzonen 5 unter den Leiterbahnen für die Teilsignale mit den Indexes 01 und 03 nicht erforderlich, soweit diese Leiterbahnen jeweils innerhalb ihrer zugehörigen n-dotierten Substratzonen geführt werden. Dieser Sachverhalt ergibt den Vorteil einer Flächeneinsparung, die allerdings aus der Fig. 10 nicht ohne weiteres ersichtlich ist, da die Abstände, wie bereits oben erwähnt, der Übersichtlichkeit wegen vergrößert wurden. Die Flächeneinsparung schlägt im übrigen erst bei langen Signalleitungen, wie sie in praktischen Fällen oft erforderlich sind, richtig zu Buche.

Abschließend ist zu vermerken, daß einige der Kontakte der A1-Leitbahnen mit dem darunter freigelegten Halbleitermaterial in der Fig. 10 mit K bezeichnet worden sind.

**Patentansprüche**

1. Integrierter CMOS-Schaltkreis mit einer Leistungsstufe in Form einer Source-Drain- Drain-Source-Reihenschaltung zweier zueinander komplementärer Isolierschicht-Feldeffekttransistoren (T1, T2), welche in je einer Substratzone (3, 4) angeordnet sind, wobei

— die Sourcezonen der Feldeffekttransistoren (T1, T2) an je einem von zwei Versorgungspotentialen (U0, U3) liegen,

— das Ausgangssignal am Verbindungspunkt (A) der beiden Drainzonen der Feldeffekttransistoren (T1, T2) abgegriffen wird,

— an den Gateelektroden gleichzeitig ein digitales Eingangssignal angelegt wird,

— die Gateelektrode des an der einen Versorgungsspannung (U3) liegenden Feldeffekttransistors (T2) mit dem Ausgang (1) eines ersten CMOS-Inverters einer Treiberstufe (Ss) verbunden ist,

— die Gateelektrode des an der anderen Versorgungsspannung ($U_0$) liegenden Feldeffekttransistors (T1) an dem Ausgang (2) eines zweiten CMOS-Inverters der Treiberstufe (Ss) liegt,

— in der Treiberstufe (Ss) das digitale Eingangssignal ($\overline{u_{03}}$) in zwei Treibersignale ($u_{23}$, $u_{01}$) gleichen Vorzeichens aufgeteilt wird, die gleichzeitig an je einem der Ausgänge (1, 2) anstehen und jeweils die Source-Gate-Spannung eines der beiden Feldeffekttransistoren (T1, T2) über seine Schleusenspannung anhebt.

— jeder der CMOS-Inverter aus einem Paar von komplementären Isolierschicht-Feldeffekttransistoren besteht, an deren Gateelektroden das Eingangssignal ($\overline{u_{03}}$) anliegt,

— der erste Transistor des ersten CMOS-Inverters mit seiner Soruceelektrode an der einen Versorgungsspannung (U3) liegt und .

— der zweite Transistor des zweiten CMOS-Inverters mit der Sourceelektrode an der anderen Versorgungsspanung ($U_0$) liegt,

dadurch gekennzeichnet,

— daß an den beiden CMOS-Invertern je eine Versorgungsspannung (U3-U2 bzw. U1-U0) anliegt, welche größer ist als die Schwellenspannung des jeweils anzusteuernden Isolierschicht-Feldeffekttransistors (T1, T2) der Leistungsstufe,jedoch kleiner ist als die Versorgungsspannung (U3-U0) des CMOS-Schaltkreises.

2. Integrierter CMOS-Schaltkreis nach Anspruch 1, dadurch gekennzeichnet,

— daß die Gateelektrode des an der einen Versorgungsspannung (U3) liegenden Feldeffekttransistors (T2) über eine erste logische Verknüpfungsschaltung mit dem Ausgang (1) des ersten CMOS-Inverters und die Gateelektrode des an der anderen Versorgungsspannung ($U_0$) liegenden Feldeffektransistors (T1) über eine zweite logische Verknüpfungsschaltung an dem Ausgang (2) des zweiten CMOS-Inverters liegen und

— daß in der Treiberstufe (Ss) das digitale Eingangssignal ($u_{03}$) in zwei Treibersignale ($u_{23}$, $u_{01}$) gleichen Vorzeichens aufgeteilt wird, die gleichzeitig an je einem der Ausgänge (1, 2) anstehen und jeweils unmittelbar oder über eine weitere logische Verknüpfungsschaltung die Source-Gate-Spannung eines der beiden Feldeffektransistoren (T1, T2) anhebt.

3. Integrierter CMOS-Schaltkreis nach Anspruch 1 oder Anspruch 2, dadurch gekennzeichnet, daß ein Treibersignal einer Treiberstufe (Ss1) mit einem weiteren Treibersignal einer weiteren Treiberstufe (Ss2) an je einem Eingang einer logischen Verknüpfungsschaltung anliegt, deren Ausgang jeweils mit einer Gateelektrode der komplementären Isolierschicht-Feldeffekttransistoren der Leistungsstufe verbunden sind.

4. Integrierter CMOS-Schaltkreis nach einem der Ansprüche 1 bis 3, dadurch gekennzeichnet,

— daß der Eingang der Treiberstufe (Ss) mit dem miteinander verbundenen Drainelektroden einer CMOS-Inverterstufe eines Pegelumsetzers (Pu) verbunden ist,

— daß die Gateelektroden der CMOS-Inverterstufe mit den Drainelektroden einer CMOS-Invertervorstufe des Pegelumsetzers (Pu) verbunden sind,

— daß an die CMOS-Inverterstufe eine größere Versorgungsspannung (U3) angelegt ist als die Versorgungsspannungen (U1) der CMOS-Invertervorstufe und

— daß der Betrag der Schwellenspannung des an der größeren Versorgungsspannung (U3) liegenden Isolierschicht-Feldeffekttransistors in seiner Größe zwischen der größeren Versorgungsspannung (U3) und der Differenz der größeren Versorgungsspannung (U3) mit der kleineren Versorgungsspannung (U1) liegt.

5. Integrierter CMOS-Schaltkreis nach einem der Ansprüche 1 bis 4, dadurch gekennzeichnet, daß der Ausgang (A) der Leistungsstufe mit der Wortleitung einer Speichermatrix mit nichtflüchtig lesbaren Feldeffekt-Speichertransistoren verbunden ist.

## Claims

1. Integrated CMOS circuit comprising a power stage in the form of a source-drain drain-source series arrangement of two complementary insulated-gate field-effect transistors (T1, T2), each of which being disposed in a substrate region (3, 4), with

— the source regions of the field-effect transistors (T1, T2) each being applied to one of two supply voltages (U0, U3),

— the output signal being taken off at the point (A) connecting the two drain regions of the field-effect transistors (T1, T2),

— a digital input signal being simultaneously applied to the gate electrodes,

— the gate electrode of the field-effect transistor (T2) as applied to the one supply voltage (U3), being connected to the output (1) of a first CMOS inverter of a driver stage (Ss),

— the gate electrode of the field-effect transistor (T1) as applied to the other supply voltage (U0), being connected to the output (2) of a second CMOS inverter of the driver stage (Ss),

— the digital input signal ($\overline{u_{03}}$) being split up in the driver stage (Ss) into two driver signals ($u_{23}$, $u_{01}$) of the same sign, which simultaneously appear at respectively one of the outputs (1, 2) and each raise the source-gate voltage of one of the two field-effect transistors (T1, T2) above its threshold voltage value,

— each of the CMOS inverters consisting of a pair of complementary insulated-gate field-effect transistors, to the gate electrodes of which the input signal ($\overline{u_{03}}$) is applied,

— the first transistor of the first CMOS inverter being connected with its source electrode to the one supply voltage (U3), and

— the second transistor of the second CMOS inverter being connected with its source electrode to the other supply voltage ($U_0$).

characterized in

— that a supply voltage (U3-U2 or U1-U0) is applied to each of the two CMOS inverters, which is higher than the threshold voltage of the respective insulated-gate field-effect transistor (T1, T2) to be controlled of the power stage, but lower than the supply voltage (U3-U0) of the CMOS circuit.

2. An integrated CMOS circuit as claimed in claim 1, characterized in

— that the gate electrode of the field-effect transistor (T2) as applied to the one supply voltage (U3) is connected, via a first logical element, to the output (1) of the first CMOS inverter, and the gate electrode of the field-effect transistor (T1) as applied to the other supply voltage ($U_0$) is connected, via a second logical element, to the output (2) of the second CMOS inverter, and

— that the digital input signal ($u_{03}$) is split up in the driver stage (Ss) into two driver signals ($u_{23}$, $u_{01}$) of the same sign, which simultaneously appear at respectively one of the outputs (1, 2) and each, either directly or via a further logical element, raise the source-gate voltage of one of the two field-effect transistors (T1, T2).

3. An integrated CMOS circuit as claimed in claim 1 or claim 2, characterized in that one driver signal of a driver stage (Ss1) together with a further driver signal of a further driver stage (Ss2) is applied to one input each of a logical element, with the output thereof being respectively connected to one gate electrode of the complementary insulated-gate field-effect transistors of the power stage.

4. An integrated CMOS circuit as claimed in one of claims 1 to 3, characterized in

— that the input of the driver stage (Ss) is connected to the interconnected drain electrodes of a CMOS inverter stage of a level converter (Pu),

— that the gate electrodes of the CMOS inverter stage are connected to the drain electrodes of a CMOS preinverter stage of the level converter (Pu),

— that to the CMOS inverter stage a supply voltage (U3) is applied which is higher than the supply voltage (U1) of the CMOS pre-inverter stage, and

— that the amount of the threshold voltage of the insulated-gate field-effect transistor as applied to the higher supply voltage (U3), ranges in its magnitude between the higher supply voltage (U3) and the difference the higher supply voltage (U3) and the lower supply voltage (U1).

5. An integrated CMOS circuit as claimed in one of claims 1 to 4, characterized in that the output (A) of the power stage is connected to the word line of a storage matrix employing non volatile readable field-effect storage transistors.

## Revendications

1. Circuit de commutation intégré CMOS avec un étage de puissance sous la forme d'un montage en série source-drain drain-source de deux transistors à effet de champ à grille isolée complémentaires l'un à l'autre (T1, T2), qui sont disposés chacun dans une zone du substrat (3, 4),

— où les zones de source des transistors à effet de champ (T1, T2) sont reliées chacun à l'un de deux potentiels d'alimentation (U0, U3),

— où le signal de sortie est prélevé au point de liaison (A) des deux zones de drain des transistors à effet de champ (T1, T2),

— où un signal d'entrée numérique est appliqué simultanément aux électrodes de grille,

— où l'électrode de grille du transistor à effet de champ (T2) relié à la première des tensions d'alimentation (U3) est reliée à la sortie (1) d'un premier inverseur CMOS d'un étage d'attaque (Ss),

— où l'électrode de grille du transistor à effet de champ (T1) relié à l'autre tension d'alimentation (U0) est reliée à la sortie (2) d'un second inverseur CMOS de l'étage d'attaque (Ss),

— où le signal numérique d'entrée ($\overline{u_{03}}$) est dédoublé dans l'étage d'attaque (Ss) en deux signaux d'attaque ($u_{23}$, $u_{01}$) de même signe qui sont produits simultanément à chacune des sorties (1, 2) et

**0 082 208**

portent la tension source-grille d'un des deux transistors à effet de champ (T1, T2) au-delà de sa tension de seuil,

— où chacun des inverseurs CMOS est composé d'une paire de transistors à effet de champ à grille isolée complémentaires aux électrodes de grille desquels est appliqué le signal d'entrée ($\overline{u_{03}}$),

— où le premier transistor du premier inverseur CMOS est relié par son électrode de source à la première des tensions d'alimentation (U3) et

— où le second transistor du second inverseur CMOS est relié par son électrode de source à l'autre tension d'alimentation (Uo),

caractérisé en ce que

— l'on applique à chacun des deux inverseurs CMOS une tension d'alimentation (U3-U2 ou U1-U0) qui est supérieure à la tension de seuil de celui qui doit être attaqué des deux transistors à effet de champ (T1, T2) à grille isolée de l'étage de puissance, mais qui est inférieure à la tension d'alimentation (U3-U0) du circuit de commutation CMOS.

2. Circuit de commutation intégré CMOS selon la revendication 1, caractérisé en ce que l'électrode de grille du transistor à effet de champ (T2) relié à la première tension d'alimentation (U3) est reliée par un premier circuit logique à la sortie (1) du premier inverseur CMOS et en ce que l'électrode de grille du transistor à effet de champ (T1) relié à l'autre tension d'alimentation (U0) est reliée par un second circuit logique à la sortie (2) du second inverseur CMOS, et

le signal numérique d'entrée ($\overline{u_{03}}$) est dédoublé dans l'étage d'attaque (Ss) en deux signaux d'attaque ($u_{23}$, $u_{01}$) de même signe qui sont produits simultanément à chacune des sorties (1, 2) et augmentent directement ou par l'intermédiaire d'un autre circuit logique la tension source-grille d'un des deux transistors à effet de champ (T1, T2).

3. Circuit de commutation intégré CMOS selon la revendication 1 ou 2, caractérisé en ce qu'un signal d'attaque d'un étage d'attaque (Ss1) est appliqué avec un autre signal d'attaque d'un autre étage d'attaque (Ss2) à chacune des entrées d'un circuit logique dont la sortie est reliée à une électrode de grille des transistors à effet de champ à grille isolée complémentaires de l'étage de puissance.

4. Circuit de commutation intégré CMOS selon l'une des revendications 1 à 3, caractérisé en ce que

— l'entrée de l'étage d'attaque (Ss) est reliée aux électrodes de drain interconnectées d'un étage d'inversion CMOS d'un convertisseur de niveau (Pu),

— les électrodes de grille de l'étage d'inversion CMOS sont reliées aux électrodes de drain d'un étage de pré-inversion CMOS du convertisseur de niveau (Pu),

— l'on applique à l'étage d'inversion CMOS une tension d'alimentation (U3) supérieure aux tensions d'alimentation (U1) de l'étage de pré-inversion CMOS et

— la valeur de la tension de seuil du transistor à effet de champ à grille isolée relié à la plus grande des tensions d'alimentation (U3) est comprise entre, d'une part, la plus grande tension d'alimentation (U3) et d'autre part la différence de cette plus grande tension d'alimentation (U3) et de la plus petite tension d'alimentation (U1).

5. Circuit de commutation intégré CMOS selon l'une des revendications 1 à 4, caractérisé en ce que la sortie (A) de l'étage de puissance est reliée à la ligne de mot d'une matrice de mémoire à transistors à effet de champ à lecture non volatile.

8

FIG.1

FIG.2

$$Pg' = f \ Cg \ (U3 - U0)^2$$

FIG.3

$$Pg = f \ Cg^2 \cdot [(U1 - U0)^2 + (U3 - U2)^2]$$

## FIG.4a

Uo = 0    $u_{01}$    $\overline{u_{03}}$    $u_{23}$    U3 = 20V

T1    5    T2

n+    n+    p+    p+    n    p+    4

p    3

## FIG.4b

$u_{23}$    U3

$\overline{u_{03}}$

$u_{01}$    Uo

## FIG.4c

| $u_{01}$ Volt | $u_{23}$ Volt | $\overline{u_{03}}$ Volt |
|---|---|---|
| 0 | 15 | 20 |
| 5 | 20 | 0 |

## FIG.5a

Uo    $u_{01}$    U1    $\overline{u_{03}}$    U2    $u_{23}$    U3

5

n+    n+    p+    p+    p+    n+    p    n+    p+    p+

n    n    p

6    7    8    p

3

## FIG.5b

Ss    U3
1    $u_{23}$
U2
$\overline{u_{03}}$    U1
$u_{01}$
2    Uo

Uo  = 0
U1  = 5V
U2  = 15V
U3  = 20V

## FIG.5c

| $\overline{u_{03}}$ Volt | $u_{01}$ Volt | $u_{23}$ Volt |
|---|---|---|
| 0 | 5 | 20 |
| 20 | 0 | 15 |

FIG. 6a

FIG. 6b

FIG. 6c

$$U0 = 0$$
$$U1 = 5V$$
$$U3 = 20V$$
$$U_T^* = -16V$$

| $u_{01}'$ Volt | $\overline{u_{01}}$ Volt | $\overline{u_{03}}$ Volt |
|---|---|---|
| 0 | 5 | 0 |
| 5 | 0 | 20 |

$$U0 < U1 < U3$$
$$U0 < u_{01} < U1$$
$$U3 - U1 < / U_T^* / < U3$$

FIG. 7a

FIG. 7b

FIG. 7c

$$U0 = 0$$
$$U1 = 5V$$
$$U2 = 15V$$
$$U3 = 20V$$

| $\overline{u_{01}}$ Volt | $u_{01}$ Volt |
|---|---|
| 5 | 0 |
| 0 | 5 |

| $\overline{u_{23}}$ Volt | $u_{23}$ Volt |
|---|---|
| 20 | 15 |
| 15 | 20 |

FIG.8

0 082 208

FIG.9

$$c_{01} = \overline{\overline{a_{01}} + b_{01}} = a_{01} \cdot \overline{b_{01}}$$

$$c_{23} = \overline{\overline{a_{23}} + b_{23}} = a_{23} \cdot \overline{b_{23}}$$

$$\overline{c_{03}} = \overline{a_{01}} + b_{01} = \overline{a_{01} \cdot \overline{b_{01}}}$$

FIG.10

6